Europäisches Patentamt

(19) **European Patent Office**

Office européen des brevets

(11) Numéro de publication: **0 267 072**
**A1**

(12) **DEMANDE DE BREVET EUROPEEN**

(21) Numéro de dépôt: **87402176.9**

(22) Date de dépôt: **30.09.87**

(51) Int. Cl.⁴: **H 03 K 5/08**

(30) Priorité: **01.10.86 FR 8613690**

(43) Date de publication de la demande:
**11.05.88 Bulletin 88/19**

(84) Etats contractants désignés: **DE ES FR GB IT**

(71) Demandeur: **JAEGER**
**2, rue Baudin**
**F-92303 Levallois-Perret (FR)**

(72) Inventeur: **Laugier, Philippe**
**12 rue de Verdun**
**F-92600 Asnières (FR)**

(74) Mandataire: **Martin, Jean-Jacques et ai**
**Cabinet REGIMBEAU 26, Avenue Kléber**
**F-75116 Paris (FR)**

(54) **Circuit de traitement de signaux électriques, en vue d'une mise en forme, en particulier de signaux provenant de capteurs pour véhicules automobiles.**

(57) La présente invention concerne un circuit de traitement d'un signal électrique, comportant un circuit de mise en forme qui comprend des moyens (510, 514, 520, 524) de détection des maxima et des minima d'un signal d'entrée, des moyens (530, 532, 534) définissant une valeur seuil de consigne correspondant à un pourcentage prédéterminé de l'écart entre le dernier maximum et le dernier minimum du signal d'entrée, et des moyens (536) de comparaison de la valeur du signal d'entrée et de la valeur seuil de consigne pour générer un signal de sortie basculant entre deux états en fonction du résultat de la comparaison. Selon l'invention le circuit de mise en forme (500) est précédé d'un convertisseur analogique/numérique (300) et les maxima et minima détectés du signal d'entrée sont stockés de façon numérique dans des moyens de mémoire (514, 524).

FIG. 5

EP 0 267 072 A1

## Description

## CIRCUIT DE TRAITEMENT DE SIGNAUX ELECTRIQUES, EN VUE D'UNE MISE EN FORME, EN PARTICULIER DE SIGNAUX PROVENANT DE CAPTEURS POUR VEHICULES AUTOMOBILES.

La présente invention concerne un circuit de traitement de signaux électriques analogiques, en vue d'une mise en forme du type défini dans le préambule de la revendication 1.

La présente invention s'applique tout particulièrement, mais non exclusivement, à la mise en forme de signaux électriques générés par des capteurs pour véhicules automobiles.

Un circuit de traitement du type défini dans le préambule de la revendication 1 est décrit dans le document US-A-3 832 577. Le principe de traitement évoqué dans ce document s'avère séduisant en théorie. Il présente cependant différents inconvénients. Le système décrit dans le document US-A-3 832 577 ne fonctionne en effet correctement que si le signal à mettre en forme possède des fronts suffisamment raides. Cet inconvénient est lié à l'utilisation d'un différentiateur et d'un comparateur de pente pour contrôler la réactualisation des maxima et minima retenus pour définir le seuil de consigne. De plus, selon le document US-A-3 832 577 la conservation de l'information analogique représentative des maxima et minima se fait sur des capacités. Le signal à traiter doit de ce fait impérativement présenter une fréquence élevée pour éviter une dérive du seuil de consigne par décharge des capacités. Le système décrit dans le document US-A-3 832 577 n'est pas utilisable avec des signaux d'entrée basse fréquence.

Un circuit de traitement généralement similaire est décrit dans le document FR-A-2 565 746.

La présente invention a pour but de perfectionner les dispositifs de traitement de signaux électriques jusqu'ici proposés et d'éliminer les inconvénients antérieurs précités. Un but principal de la présente invention est de proposer un circuit d'interface assurant la mise en forme de signaux électriques, apte à recevoir des signaux dont la fréquence et l'amplitude évoluent dans une large gamme, par exemple entre 0,5 Hz et 20kHz pour la fréquence.

Un autre but de la présente invention est de proposer un circuit de mise en forme de signaux électriques générés par des capteurs, apte à recevoir à la fois des signaux électriques dont l'information utile est d'ordre fréquentiel, et des signaux électriques dont l'information utile est représentée par l'amplitude des signaux.

Un autre but de la présente invention est de proposer un circuit de mise en forme de signaux électriques apte à recevoir une multiplicité de signaux générés par des capteurs sensibles à des paramètres de fonctionnement d'un véhicule automobile, tels que par exemple des capteurs sensibles au régime, à la vitesse, au débit du carburant, ou au niveau de carburant dans le réservoir.

Un autre but de la présente invention est de proposer un circuit de mise en forme apte à traiter des signaux présentant de fortes variations d'amplitude crête à crête, s'affranchir d'importants parasites impulsionnels, fonctionner jusqu'à des fréquences nulles, supporter des accélérations en fréquence très importantes (pouvant atteindre 20KHz/s).

Dans le cadre de la présente invention, la mise en forme de signaux électriques dont l'information utile est représentée par la fréquence, consiste à convertir ces signaux en signaux logiques de même fréquence, de préférence en combinaison avec une conversion analogique/numérique. La mise en forme de signaux électriques dont l'information utile est représentée par l'amplitude consiste en une conversion analogique/numérique.

Ces différents buts sont atteints selon la présente invention grâce aux dispositions spécifiées dans la partie caractérisante de la revendication 1 annexée.

D'autres caractéristiques préférentielles sont précisées dans les revendications dépendantes annexées.

D'autres caractéristiques, buts et avantages de la présente invention apparaîtront à la lecture de la description détaillée qui va suivre et en regard des dessins annexés, donnés à titre d'exemple non limitatif et sur lesquels :

- la figure 1 représente une vue schématique d'ensemble, sous forme de blocs fonctionnels, du circuit conforme à la présente invention,

- la figure 2 représente une vue détaillée des filtres et du multiplexeur d'entrée,

- la figure 3 représente schématiquement le sous-ensemble assurant la gestion de la conversion analogique/numérique,

- la figure 4 représente un chronogramme du fonctionnement du sous-ensemble de gestion,

- la figure 5 représente une vue schématique du sous-ensemble assurant la remise en forme des signaux,

- la figure 6 représente schématiquement un module du sous-ensemble de remise en forme,

- la figure 7 représente schématiquement la structure d'un sous-ensemble formant suppresseur de parasites,

- la figure 8 représente différents signaux illustrant le fonctionnement du sous-ensemble de remise en forme,

- la figure 9 représente un organigramme de fonctionnement du sous-ensemble de remise en forme,

- la figure 10 représente schématiquement la structure d'un sous-ensemble de cadencement du circuit conforme à la présente invention, et

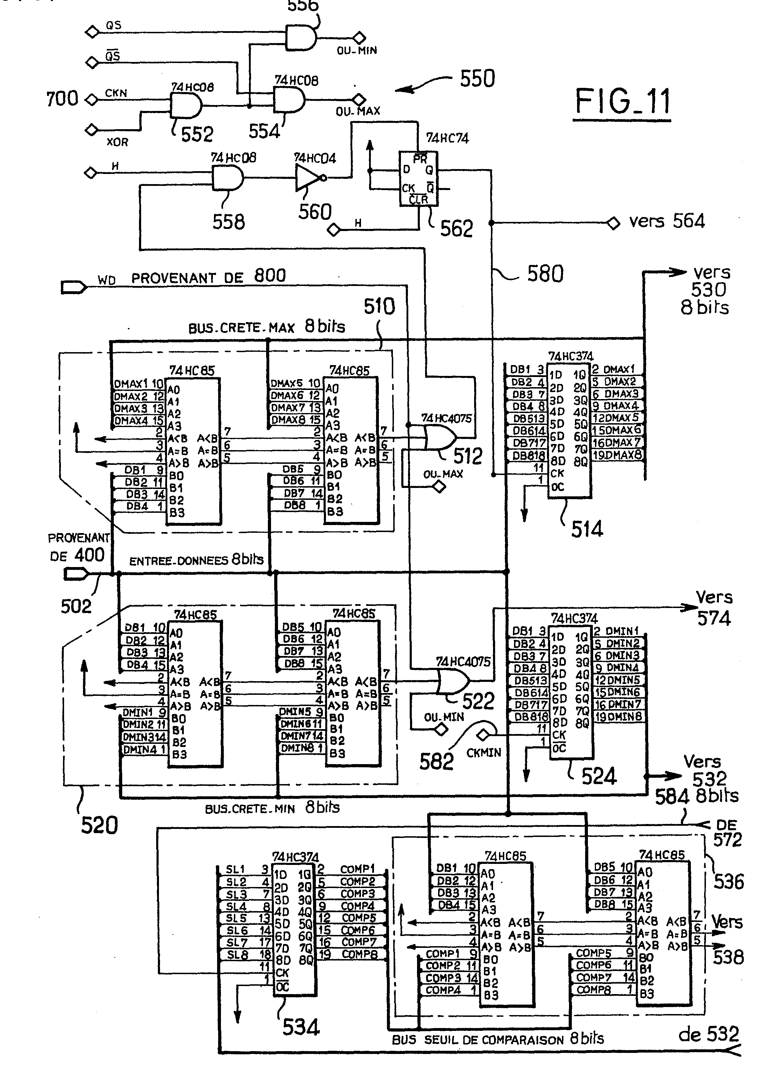

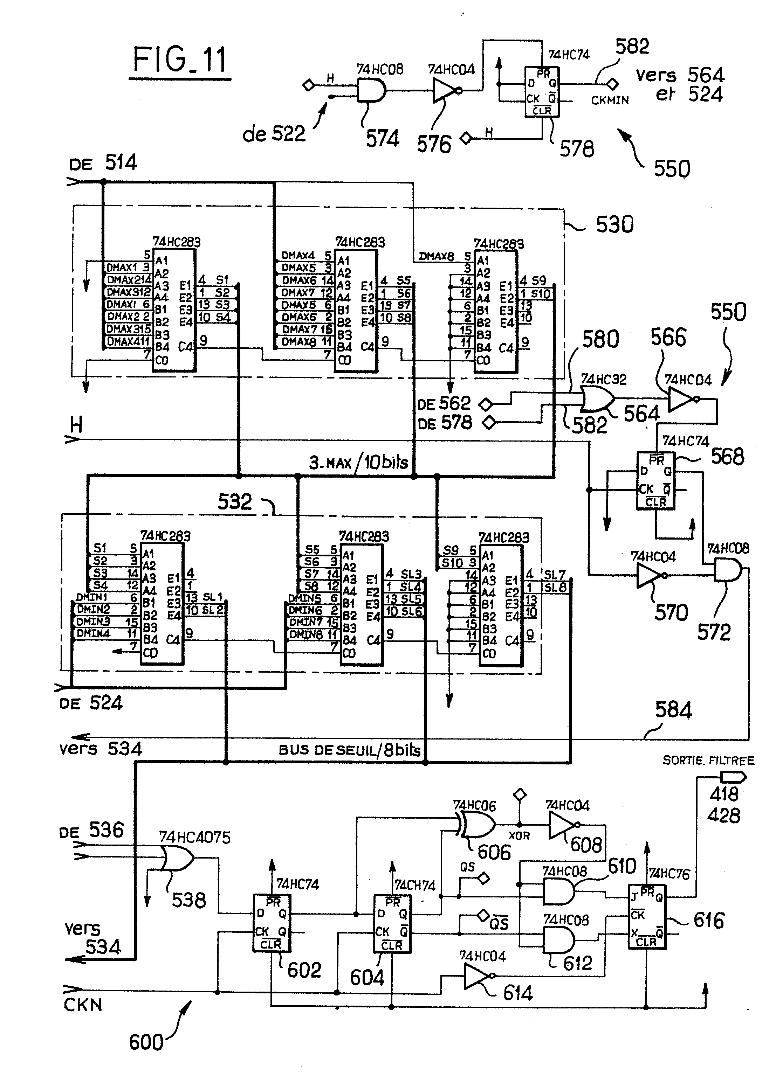

- la figure 11 représente une vue de détail d'un mode de réalisation préférentiel du sous-ensemble assurant la remise en forme des signaux.

Pour faciliter la compréhension de la structure du circuit conforme à la présente invention, on va maintenant décrire ce circuit dans le cadre d'une application aux véhicules automobiles, sous forme d'une interface entre un ensemble de capteurs sensibles à différents paramètres de fonctionnement du véhicule, et un circuit de traitement.

Néanmoins, le circuit conforme à la présente invention n'est bien entendu pas limité à une telle application.

Sur les figures annexées, la présence d'une barre transversale inclinée sur les traits de liaison électrique illustre un bus multibits.

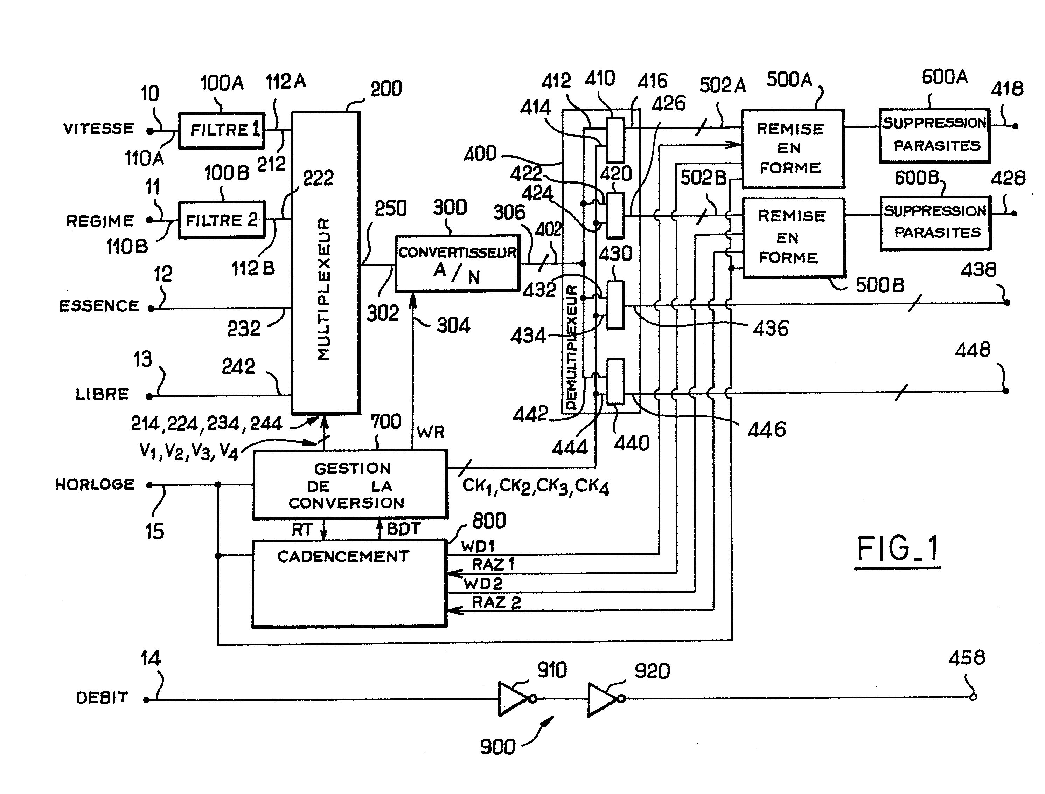

Le circuit représenté schématiquement sur la figure 1 comprend 5 entrées principales 10, 11, 12, 13 et 14 qui reçoivent des signaux en provenance de capteurs sensibles respectivement à la vitesse du véhicule, au régime, au niveau d'essence, à un paramètre libre et au débit de carburant.

Le circuit comprend également une entrée auxiliaire 15 qui reçoit un signal d'horloge, par exemple à 1MHz.

Les capteurs destinés à être reliés aux entrées 10, 11 et 14 délivrent des informations fréquentielles.

Par contre, les capteurs destinés à être reliés aux entrées 12 et 13 délivrent des informations continues analogiques, c'est-à-dire des signaux dont l'information est contenue dans une amplitude.

Pour l'essentiel, le circuit conforme à la présente invention illustré sur la figure 1 comprend deux filtres d'entrée 100A, 100B, un multiplexeur 200, un convertisseur analogique numérique 300, un démultiplexeur 400, deux sous-ensembles de remise en forme 500A, 500B, deux sous-ensembles suppresseur de parasites 600A, 600B, un sous-ensemble 700 assurant la gestion de la conversion analogique numérique, un organe de cadencement 800 et un étage 900 de mise en forme des signaux appliqué à l'entrée 14.

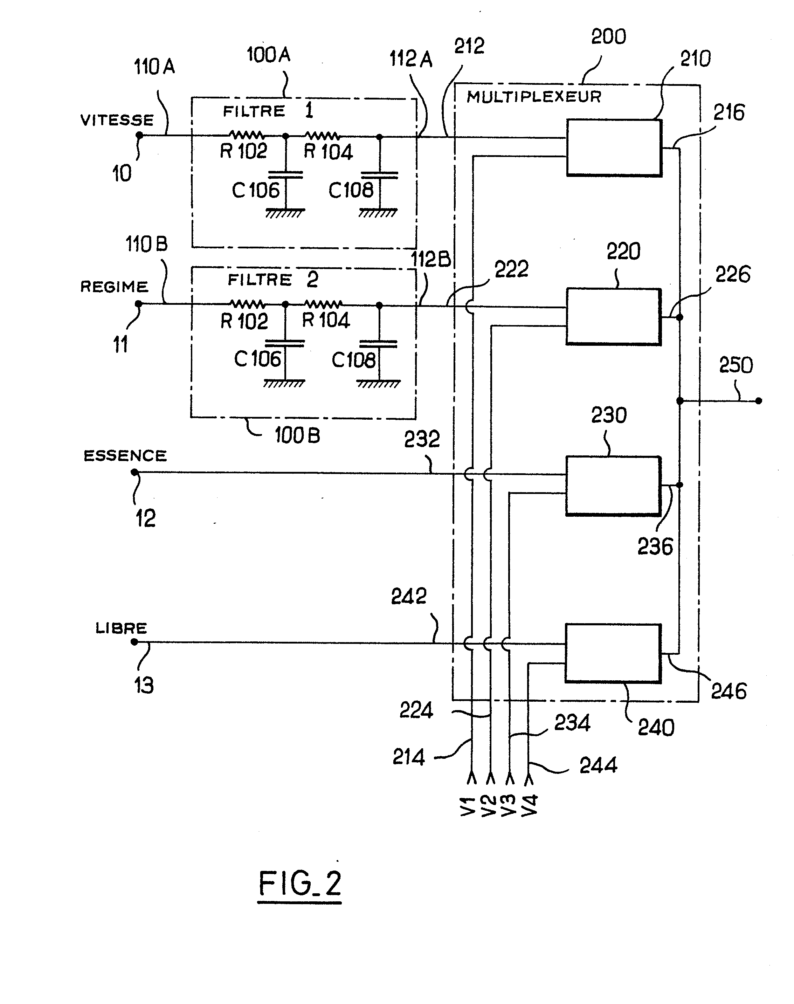

Comme illustré sur la figure 2, les filtres 100A et 100B sont des filtres passe-bas du deuxième ordre, identiques. Ils reçoivent respectivement les signaux vitesse et régime appliqués sur les entrées 10 et 11 du circuit.

Chacun des filtres 100A et 100B comprend deux résistances R102, R104 et deux capacités C106, C108. Les entrées 110A, 110B des filtres sont reliées respectivement aux entrées principales 10 et 11 du circuit. Les résistances R102 et R104 sont reliées en série entre les entrées 110A, 110B et les sorties 112A, 112B des filtres. Le premier condensateur C106 relie le point commun aux résistances R102 et R104 à la masse. Le second condensateur C108 relie la sortie 112A, 112B des filtres à la masse.

A titre d'exemple, les résistances R102 et R104 peuvent avoir une valeur de 22KΩ, tandis que les condensateurs C106 et C108 ont une capacité de 470 pF.

Le multiplexeur 200 illustré sur la figure 2 possède 4 portes 210, 220, 230 et 240. Il peut s'agir par exemple de 4 interrupteurs analogiques CMOS type 74HC 40 66. Les entrées principales 212, 222, 232 et 242 de ces portes son reliées respectivement à la sortie 112A du filtre 100A, à la sortie 112B du filtre 100B, à l'entrée principale 12 et à l'entrée principale 13.

Les entrées de commande 214, 224, 234, et 244 des portes 210, 220, 230 et 240, qui déterminent le temps d'ouverture de celles-ci, reçoivent des signaux de commande V1, V2, V3 et V4 générés par le sous-ensemble de gestion 700.

Les sorties 216, 226, 236 et 246 des portes 210, 220, 230 et 240 sont raccordées en commun au niveau de la sortie 250 du multiplexeur 200.

De préférence, la fréquence d'échantillonnage des signaux appliqués sur les entrées principales 12 et 13, fréquence d'échantillonnage définie par les signaux V3 et V4, est beaucoup plus faible que la fréquence d'échantillonnage des signaux appliqués sur les entrées principales 10 et 11, qui est définie par les signaux d'échantillonnage V1 et V2.

L'entrée 302 du convertisseur analogique/numérique 300 est reliée à la sortie 250 du multiplexeur 200. De préférence, afin de réduire le nombre de bits du convertisseur analogique/numérique 300, ce dernier réalise une conversion non linéaire sur 4 bits.

La conversion analogique/numérique réalisée par le convertisseur 300 est commandée par un signal WR de demande de conversion appliquée sur l'entrée 304 du convertisseur. Le signal WR est généré par le sous-ensemble 700 de gestion de la conversion, comme cela sera explicité par la suite. Le signal WR est bien entendu synchronisé avec les signaux de multiplexage V1, V2, V3 et V4 appliqués au multiplexeur 200.

La sortie 306 du convertisseur 300 est reliée à un bus d'entrée 402 du démultiplexeur 400. Selon le mode de réalisation représenté sur la figure 1, le démultiplexeur 400 comprend 4 portes 410, 420, 430 et 440. Chacune de ces portes regroupe par exemple un nombre de bascules D égal au nombre de bits de sortie du convertisseur 300.

Chacune des portes 410, 420, 430 et 440 peut par exemple être formée d'un circuit type 74HC374. Les entrées principales 412, 422, 432 et 442 des portes 410, 420, 430 et 440 sont reliées en commun au bus d'entrée 402. Les entrées de commande de rafraîchissement 414, 424, 434 et 444 des portes 410, 420, 430 et 440 (entrées CK des circuits 74HC374) reçoivent des signaux de commande CK1, CK2, CK3 et CK4 respectivement, générés par le sous-ensemble 700 et bien entendu synchronisés avec les signaux des multiplexages V1, V2, V3 et V4.

Le bus de sortie 416 de la porte 410, qui reçoit un signal numérique correspondant au signal appliqué à l'entrée principale 10 est relié à l'entrée 502A d'un circuit de remise en forme 500A.

Le bus de sortie 426 de la porte 420 qui reçoit un signal numérique correspondant au signal appliqué sur l'entrée principale 11 est relié à l'entrée 502B d'un circuit de remise en forme 500 .

Enfin, le bus de sortie 436 et 446 des portes 430 et 440 qui reçoivent respectivement des signaux numériques correspondant aux signaux analogiques appliqués aux entrées principales 12 et 13, sont reliés à des bus de sortie 438 et 448.

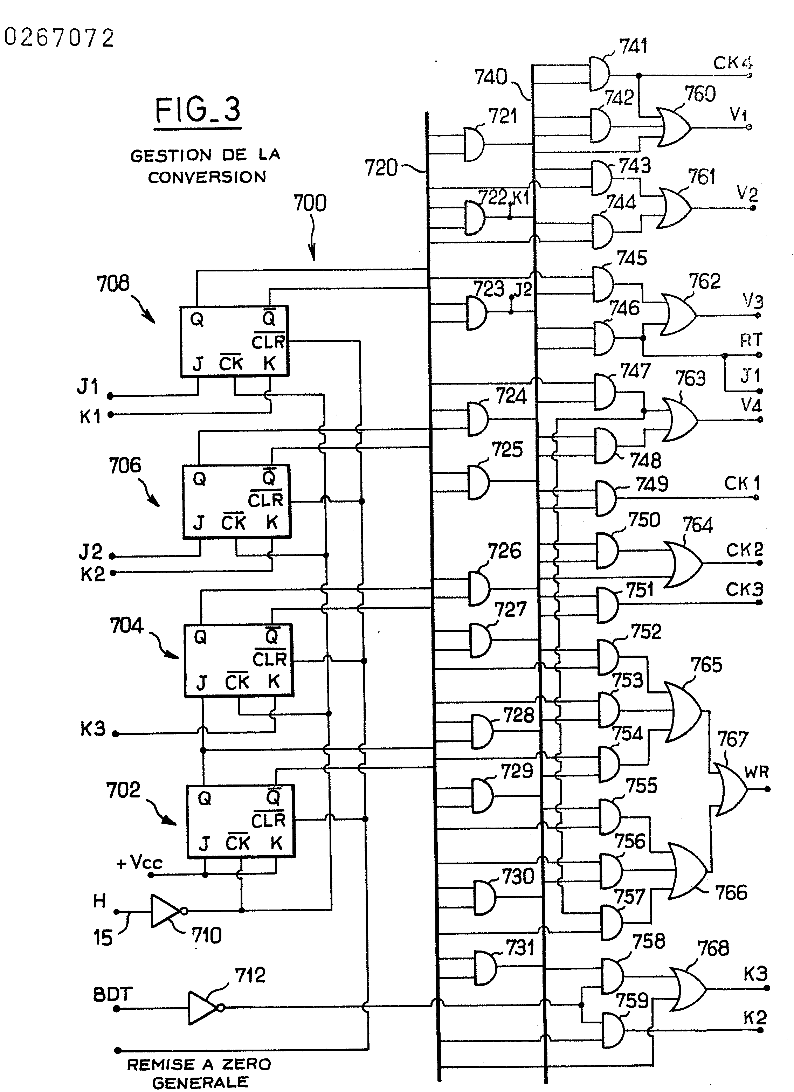

On va maintenant décrire la structure du circuit de gestion 700 représenté sur la figure 3.

Ce circuit a pour but de fournir des signaux au multiplexeur 200, au convertisseur 300, au démultiplexeur 400 et au circuit de cadencement 800.

Le circuit de gestion 700 reçoit un signal BDT du circuit de cadencement 800 et il est synchronisé par l'horloge générale H du circuit, par exemple d'une fréquence de 1 MHz.

Selon la représentation schématique donnée sur la figure 3 le circuit de gestion 700 comprend 4 bascules JK 702, 704, 706 et 708, trente portes à deux entrées référencées 721 à 731 et 741 à 759, deux inverseurs 710 et 712, 6 portes OU à deux entrées 761, 762, 763, 764, 767 et 768 et 3 portes OU à trois entrées 760, 765 et 766.

Le circuit 700 comprend un premier bus auxiliaire 720 à 8 bits et un second bus auxiliaire 740 à 11 bits.

La signal d'horloge H à 1 MHz est appliqué par l'intermédiaire de l'inverseur 710 sur les entrées d'horloge $\overline{CK}$ des bascules 702, 704, 706 et 708.

Les entrées J et K de la première bascule 702 sont reliées à une tension d'alimentation positive +Vcc.

La sortie Q de la première bascule 702 est réliée à l'entrée J de la seconde bascule 704. La sortie Q de la première bascule 702 est également reliée à une première ligne du bus secondaire 720.

La sortie $\overline{Q}$ de la première bascule 702 est reliée à une seconde ligne du bus secondaire 720.

L'entrée K de la seconde bascule 704 reçoit un signal référencé K3 qui sera explicité par la suite.

Les sorties Q et $\overline{Q}$ de la seconde bascule 704 sont reliées respectivement à une troisième ligne et à une quatrième ligne du bus secondaire 720.

Les entrées J et K de la troisième bascule 706 reçoivent respectivement des signaux référencés $J_2$ et $K_2$ qui seront explicités par la suite.

Les sorties Q et $\overline{Q}$ de la troisième bascule 706 sont reliées respectivement à une cinquième ligne et à une sixième ligne du bus secondaire 720.

Les entrées J et K de la quatrième bascule 708 reçoivent respectivement des signaux référencés $J_1$ et $K_1$ qui seront explicités par la suite.

Les sorties Q et $\overline{Q}$ de la quatrième bascule 708 sont reliées respectivement à une septième et à une huitième lignes du bus secondaire 720.

Les entrées de remise à zéro ($\overline{CLR}$) des bascules 702, 704, 706 et 708 sont reliées à une ligne de remise à zéro générale du circuit.

Les entrées de la porte ET721 sont reliées respectivement à la cinquième et à la septième lignes du bus secondaire 720 (sorties Q des bascules 706 et 708). La sortie de la porte ET 721 est reliée à une première ligne du bus secondaire 740.

Les entrées de la porte ET722 sont reliées respectivement aux troisième et cinquième lignes du bus secondaire 720 (sorties Q des bascules 704 et 706). La sortie de la porte ET 722 est reliée à une deuxième ligne du bus secondaire 740 et génère le signal $K_1$ précité.

Les entrées de la porte ET723 sont reliées respectivement aux première et troisième lignes du bus secondaire 720 (sorties Q des bascules 702 et 704). La sortie de la porte ET723 est reliée à une troisième ligne du bus secondaire 740 et génère le signal $J_2$.

Les entrées de la porte ET 724 sont reliées respectivement à la première et à la septième lignes du bus secondaire 720 (sorties Q des bascules 702 et 708). La sortie de la porte ET 724 est reliée à une quatrième ligne du bus secondaire 740.

Les entrées de la porte ET 725 sont reliées respectivement à la première et à la cinquième lignes du bus secondaire 720 (sorties Q des bascules 702 et 706). La sortie de la porte ET 725 est reliée à une cinquième ligne de bus secondaire 740.

Les entrées de la porte ET 726 sont reliées respectivement à la sixième et à la huitième lignes du bus secondaire 720 (sorties $\overline{Q}$ des bascules 706 et 708). La sortie de la porte ET 726 est reliée à une sixième ligne du bus secondaire 740.

Les entrées de la porte ET 727 sont reliées respectivement à la quatrième et à la huitième lignes du bus secondaire 720 (sorties $\overline{Q}$ des bascules 704 et 708). La sortie de la porte ET 727 est reliée à une septième ligne du bus secondaire 740.

Les entrées de la porte ET 728 sont reliées respectivement à la cinquième et à la huitième lignes du bus secondaire 720 (sortie Q de la bascule 706 et sortie $\overline{Q}$ de la bascule 708). La sortie de la porte ET 728 est reliée à une huitième ligne du bus secondaire 740.

Les entrées de la porte ET 729 sont reliées respectivement à la quatrième et à la septième lignes du bus secondaire 720 (sortie $\overline{Q}$ de la bascule 704 et sortie Q de la bascule 708). La sortie de la porte ET 709 est reliée à la neuvième ligne du bus secondaire 740.

Les entrées de la porte ET 730 sont reliées respectivement à la seconde et à la troisième lignes du bus secondaire 720 (entrée $\overline{Q}$ de la bascule 702 et entrée Q de la bascule 704). La sortie de la porte ET 730 est reliée à une dixième ligne du bus secondaire 740.

Les entrées de la porte ET 731 sont reliées respectivement à la seconde et à la quatrième lignes du bus secondaire 720 (sorties $\overline{Q}$ des bascules 702 et 704). La sortie de la porte ET 731 est reliée à une onzième ligne du bus secondaire 740.

Les entrées de la porte ET 741 sont reliées respectivement à la première et à la deuxième lignes du bus secondaire 740.

Les entrées de la porte ET 742 sont reliées respectivement à la première et à la cinquième lignes du bus secondaire 740.

Les entrées de la porte ET743 sont reliées respectivement à la septième ligne du bus secondaire 740 et à la cinquième ligne du bus secondaire 720.

Les entrées de la porte E744 sont reliées respectivement à la sixième ligne du bus secondaire 740 et à la deuxième lignes du bus secondaire 720.

Les entrées de la porte E745 sont reliées respectivement à la quatrième ligne du bus secondaire 720 et à la sixième ligne du bus secondaire 740.

Les entrées de la porte ET 746 sont reliées respectivement à la troisième ligne et à la seconde ligne du bus secondaire 740.

Les entrées de la porte ET 747 sont reliées respectivement à la troisième ligne du bus secondaire 720 et à la neuvième ligne du bus secondaire 740.

Les entrées de la porte ET748 sont reliées respectivement à la première et à la onzième lignes du bus secondaire 740.

Les entrées de la porte ET 749 sont reliées respectivement à la septième et à la cinquième lignes du bus secondaire 740.

Les entrées de la porte ET 750 sont reliées respectivement à la huitième et à la dixième lignes du bus secondaire 740.

Les entrées de la porte ET 751 sont reliées respectivement à la neuvième et à la troisième lignes du bus secondaire 740.

Les entrées de la porte ET 752 sont reliées respectivement à la onzième ligne du bus secondaire 740 et à la cinquième ligne du bus secondaire 720.

Les entrées de la porte ET 753 sont reliées respectivement à la première ligne du bus secondaire 720 et à la sixième ligne du bus secondaire 740.

Les entrées de la porte ET754 sont reliées respectivement à la huitième ligne du bus secondaire 720 et à la deuxième ligne du bus secondaire 740.

Les entrées de la porte ET755 sont reliées respectivement à la première ligne du bus secondaire 740 et à la quatrième ligne du bus secondaire 720.

Les entrées de la porte ET756 sont reliées respectivement à la quatrième ligne du bus secondaire 720 et à la quatrième ligne du bus secondaire 740.

Les entrées de la porte ET 757 sont reliées respectivement à la sortie de la porte ET747 et à la seconde ligne du bus secondaire 720.

Les entrées de la porte ET758 sont reliées respectivement à la sixième ligne du bus secondaire 740 et à la sortie de l'inverseur 712 qui reçoit en entrée le signal BDT en provenance du sous-ensemble de cadencement 800.

Les entrées de la porte ET759 sont reliées respectivement à la troisième ligne du bus secondaire 720 et à la sortie de l'inverseur 712.

Les entrées de la porte OU 760 sont reliées respectivement à la sortie de la porte ET741 , à la sortie de la porte ET742 et à la sixième ligne du bus secondaire 740.

Les entrées de la porte OU 761 sont reliées respectivement aux sorties des portes ET 743 et 744.

Les entrées de la porte OU 762 sont reliées respectivement aux sorties des portes ET745 et 746.

Les entrées de la porte OU 763 sont reliées respectivement aux sorties des portes ET 747 et 748.

Les entrées de la porte OU 764 sont reliées respectivement à la sortie de la porte ET750 et à la neuvième ligne du bus secondaire 740.

Les entrées de la porte OU 765 sont reliées respectivement aux sorties des portes ET752, 753 et 754.

Les entrées de la porte OU 766 sont reliées respectivement aux sorties des portes ET755, 756 et 757.

Les entrées de la porte OU 767 sont reliées respectivement aux sorties des portes OU 765 et 766.

Enfin, les entrées de la porte OU 768 sont reliées respectivement à la sortie de la porte ET758 et à la première ligne du bus secondaire 720.

Les signaux $J_1$, $K_2$ et $K_3$ appliqués aux bascules 708, 706 et 704 sont prélevés respectivement en sortie de la porte ET746, de la porte ET759 et de la porte OU 768.

Les signaux de multiplexage V1, V2, V3 et V4 appliqués respectivement sur les portes 210, 220, 230 et 240 du multiplexeur 200 sont générés en sortie de la porte OU 760 , de la porte OU 761, de la porte OU 762 et de la porte OU 763.

Les signaux de démultiplexage $CK_1$, $CK_2$, $CK_3$ et $CK_4$ appliqués respectivement aux portes 410, 420, 430 et 440 du démultiplexeur 400 sont générés en sortie respectivement de la porte ET 749, de la porte OU764, de la porte ET 751 et de la porte ET741.

Le signal WR de demande de conversion appliqué sur l'entrée 304 du convertisseur 300 est généré en sortie de la porte OU767.

Le signal RT appliqué sur le sous-ensemble de cadencement 800 est généré en sortie de la porte ET 746.

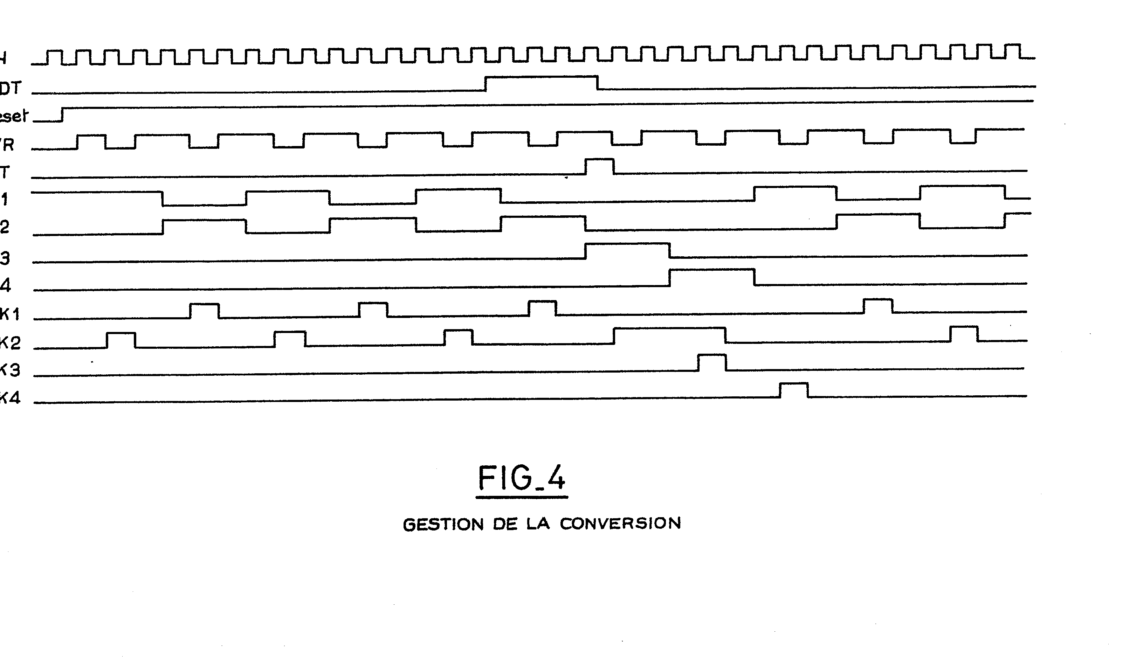

On a représenté sur la figure 4 un chronogramme schématique des signaux obtenus en sortie du circuit de conversion 700.

La première ligne du chronogramme représente le signal d'horloge H appliqué à l'entrée de l'inverseur 710.

La seconde ligne du chronogramme représente le signal BDT généré par le sous-ensemble de cadencement 800 et appliqué à l'entrée de l'inverseur 712.

La troisième ligne du chronogramme représente le signal de remise à zéro générale appliqué sur l'entrée correspondante $\overline{CK}$ des bascules 702, 704, 706 et 708.

La quatrième ligne du chronogramme représente le signal WR de commande de conversion appliqué à l'entrée 304 du convertisseur 300 et généré en sortie de la porte OU 767.

La cinquième ligne du chronogramme représente le signal RT obtenu en sortie de la porte ET 746 et appliqué au sous-ensemble de cadencement 800.

Les sixième, septième, huitième et neuvième lignes du chronogramme représentent respectivement les signaux de multiplexage V1, V2, V3 et V4 appliqués au multiplexeur 200.

Enfin, les dixième, onzième, douzième et treizième lignes du chronogramme illustré sur la figure 4 représentent les signaux $CK_1$, $CK_2$, $CK_3$ et $CK_4$ appliqués respectivement aux portes 410, 420, 430 et 440 du démultiplexeur 400.

On notera à l'examen de la figure 4 que comme indiqué précédemment, la fréquence d'échantillonnage, déterminée par les signaux $V_1$ et $V_2$, des signaux appliqués sur les entrées principales 10 et 11 est supérieure à la fréquence d'échantillonnage, déterminée par les signaux $V_3$ et $V_4$, des signaux appliqués sur les entrées principales 12 et 13.

Néanmoins, les figures 3 et 4 nesont données qu'à titre d'illustration non limitative.

De façon préférentielle le circuit de gestion 700 détermine, pour les signaux appliqués sur les entrées principales 10 et 11 une fréquence d'échantillonnage de 167 Khz, tandis qu'il détermine pour les signaux appliqués aux entrées principales 12 et 13 une fréquence d'échantillonnage de 1,9 Hz.

Le circuit représenté sur la figure 3 annexée peut aisément être adapté par l'homme de l'art, par adjonction de bascules et/ou diviseurs de fréquence pour obtenir les fréquences d'échantillonnage indiquées ci-dessus.

Les circuits de mise en forme 500A et 500B sont destinés à transformer en signaux logiques de même fréquence les signaux numérisés appliqués sur les entrées 10 et 11 (Régime et Vitesse). Ces circuits de mise en forme 500A et 500B sont adaptés pour traiter des signaux présentant de fortes variations d'amplitude crête à crête, s'affranchir d'importants parasites impulsionnels, fonctionner jusqu'à des fréquences nulles, supporter des accélérations en fréquence très importantes (pouvant atteindre 20KHz/s).

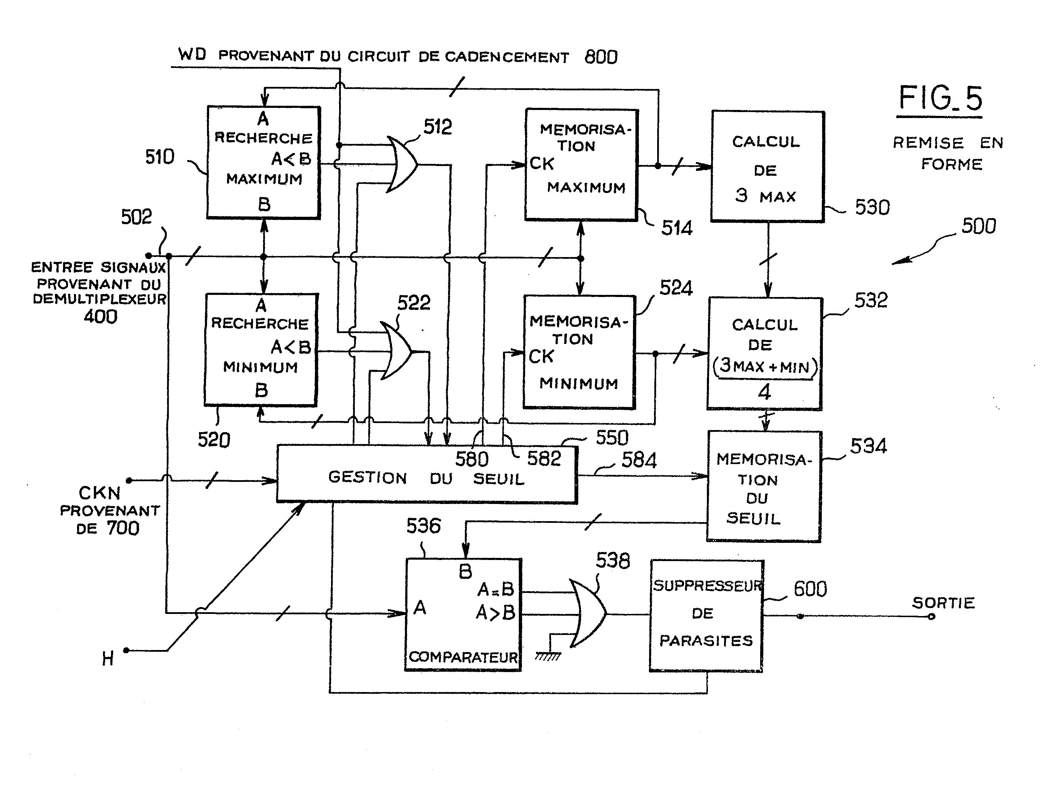

Les circuits de remise en forme 500A et 500B sont de structure identique. Cette structure est schématisée sur la figure 5.

Pour l'essentiel, ces circuits de remise en forme 500 ont pour but de comparer le signal associé issu du démultiplexeur 400 à une valeur de seuil afin de transformer le signal d'entrée en un signal en créneau net, de même fréquence que le signal d'entrée.

Comme indiqué précédemment, pour tenir compte des fortes variations d'amplitude crête à crête du signal utile tout en éliminant les signaux parasites, selon l'invention, la valeur de seuil est définie par un pourcentage de l'écart entre les maxima et les minima du signal d'entrée appliqué aux circuits de mise en forme 500.

Le circuit de remise en forme illustré sur la figure 5 comprend un bus d'entrée 502. Celui-ci est relié à un ensemble de recherche de maximum 510, à une cellule numérique de mémorisation de maximum 514, à un ensemble de recherche de minimum 520 et à une cellule numérique de mémorisation de minimum 524.

L'ensemble de recherche de maximum est formé d'un comparateur multibits qui compare le signal numérique apparaissant sur le bus d'entrée 502 à la valeur du maximum mémorisé dans la cellule 514, pour commander, par l'intermédiaire d'une porte 512, la mémorisation d'un nouveau signal dans la cellule 514 dès lors que le signal présent sur le bus d'entrée 502 est supérieur au signal mémorisé dans cette cellule.

De façon similaire, l'ensemble de recherche de minimum 520 est formé d'un comparateur multibits qui compare le signal numérique présent sur le bus d'entrée 502 à la valeur du minimum mémorisé dans la cellule 524 pour commander, par l'intermédiaire d'une porte 522, la mémorisation d'un nouveau signal dans la cellule 524 dès lors que le signal présent sur le bus d'entrée 502 est inférieur à la valeur du minimum mémorisé précédemment dans la cellule 524.

A titre d'exemple, l'ensemble de recherche de maximum 510 et l'ensemble de recherche de minimum 520 peuvent être formés de deux comparateurs 4 bits type 74HC85 montés en cascade dont on utilise soit la sortie A > B, soit la sortie A < B, reliées respectivement à la porte de commande 512 ou 522. Les cellules de mémorsation 514 et 524 peuvent être formées de bascules D, par exemple sous forme de circuit 74HC374.

Selon l'invention, d'une façon générale, le seuil auquel est comparé le signal présent sur le bus d'entrée 502 correspond à 75 % de l'amplitude crête-crête du signal, c'est-à-dire 75 % de l'écart entre les maxima et minima du signal d'entrée.

Un calcul rapide montre que en appelant la valeur du maximum : Max et en appelant la valeur du minimum :min, le seuil précité correspond à (3 Max + min)/4.

Ce seuil est déterminé, comme illustré sur la figure 5, par deux ensembles d'additionneurs numériques 530, 532.

L'ensemble 530, qui est relié à la cellule de mémorisation de maximum 514 génère un signal égal à 3 Max.

Le signal issu de l'ensemble 530 est appliqué à l'ensemble 532 qui est relié par ailleurs à la sortie de la cellule de mémorisation de minimum 524.

L'ensemble additionneur 532 génère ainsi un signal égal à (3 Max + min)/4. Cette valeur correspond au seuil recherché.

A titre d'exemple, l'ensemble de calcul 530 peut être formé de trois additionneurs type 74HC283 montés en cascade. Par ailleurs, l'ensemble de calcul 532 peut être formé de trois additionneurs type 74HC283 montés en cascade, dont on ne retient que les bits de plus fort poids.

La valeur du seuil est générée par l'ensemble 532 et mémorisée dans une cellule numérique de mémorisation 534. tivement à la porte de commande 512 ou 522. Les cellules de mémorisation 514 et 524 peuvent être formées de bascules D, par exemple sous forme de circuit 74HC374.

Selon l'invention, d'une façon générale, le seuil auquel est comparé le signal présent sur le bus d'entrée 502 correspond à 75 % de l'amplitude crête-crête du signal, c'est-à-dire 75 % de l'écart entre les maxima et minima du signal d'entrée.

Un calcul rapide montre que en appelant la valeur du maximum : Max et en appelant la valeur du minimum :min, le seuil précité correspond à (3 Max + min)/4.

Ce seuil est déterminé, comme illustré sur la figure 5, par deux ensembles d'additionneurs numériques 530, 532.

L'ensemble 530, qui est relié à la cellule de mémorisation de maximum 514 génère un signal égal à 3 Max.

Le signal issu de l'ensemble 530 est appliqué à l'ensemble 532 qui est relié par ailleurs à la sortie de la cellule de mémorisation de minimum 524.

L'ensemble additionneur 532 génère ainsi un signal égal à (3 Max + min)/4. Cette valeur correspond au seuil recherché.

A titre d'exemple, l'ensemble de calcul 530 peut être formé de trois additionneurs type 74HC283 montés en cascade. Par ailleurs, l'ensemble de calcul 532 peut être formé de trois additionneurs type 74HC283 montés en cascade, dont on ne retient que les bits de plus fort poids.

La valeur du seuil est générée par l'ensemble 532 et mémorisée dans une cellule numérique de mémorisation 534.

De façon similaire aux cellule 514 et 524, la cellule de mémorisation 534 peut être formée de circuit à base de bascules D, par exemple du type 74HC374.

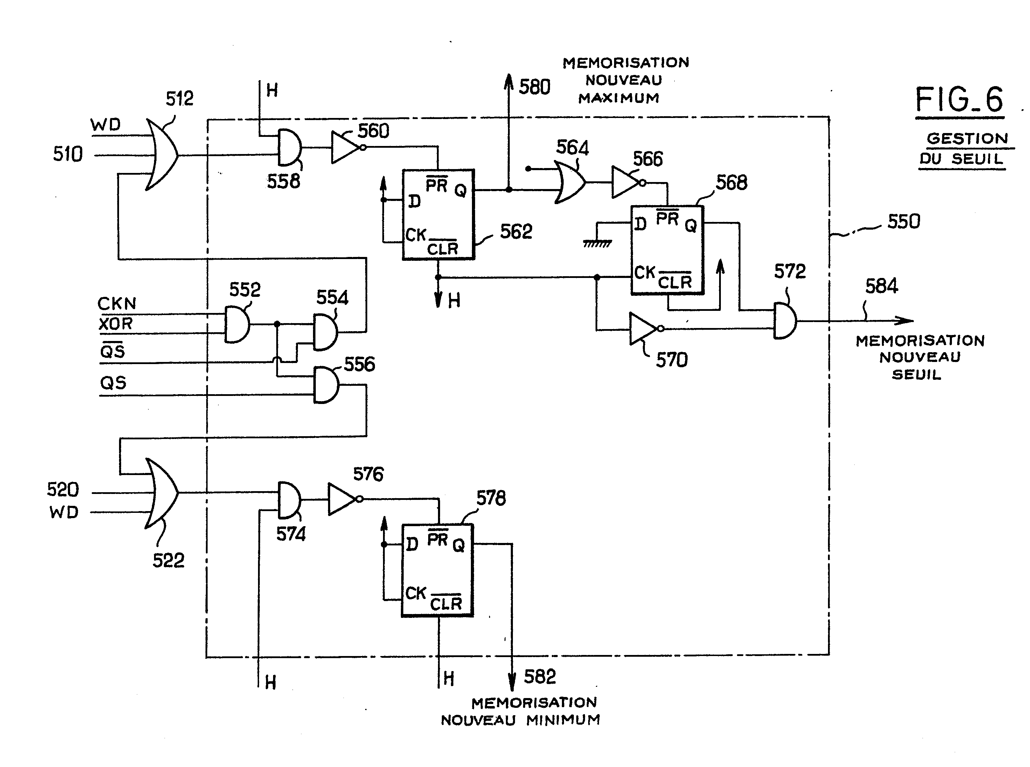

La mémorisation du seuil dans la cellule 534 est commandée par un ensemble de gestion du seuil 550 illustré sur la figure 6 et qui sera décrit plus en détail par la suite.

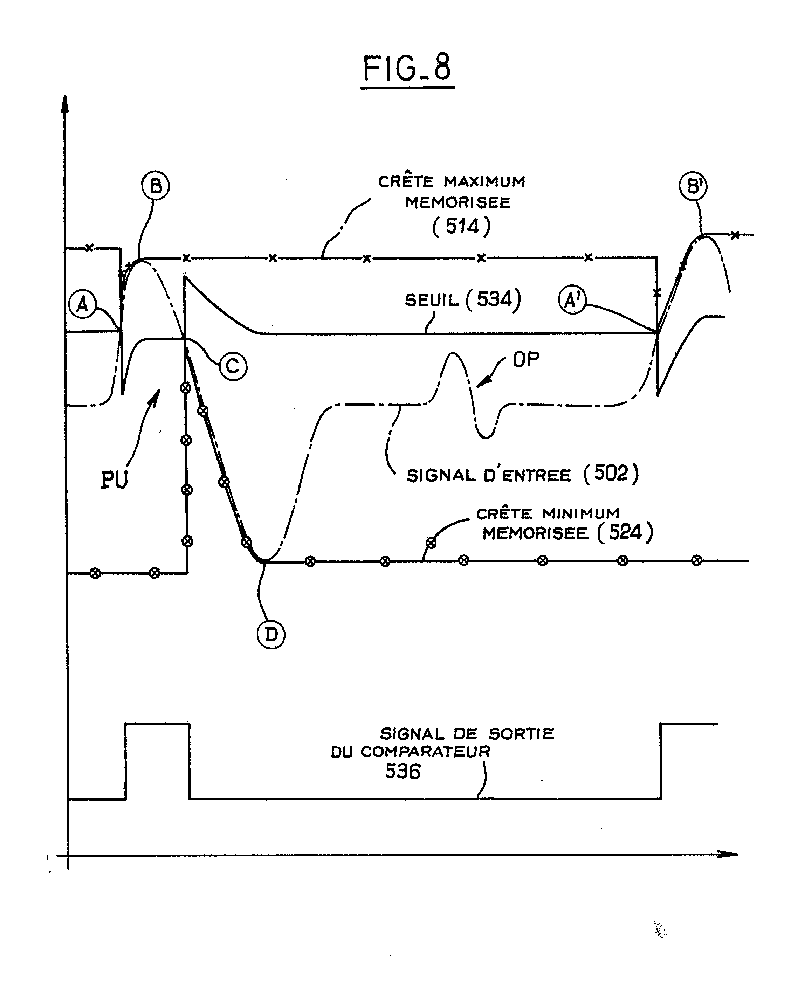

On notera que l'ensemble de gestion du seuil 550 est adapté pour rafraîchir la valeur du seuil mémorisé dans la cellule 534, d'une part, en cas d'évolution du maximum et du minimum, afin de conserver une valeur de seuil acceptable, même en cas d'évolution de l'amplitude du signal à fréquence élevée, d'autre part, à chaque détection de franchissement du seuil par le signal, afin de générer un seuil à hystérésis, tel qu'illustré schématiquement sur la figure 8, afin d'affranchir la mise en forme d'importants parasites impulsionnels susceptibles d'être superposés au signal.

Comme illustré sur la figure 5, le circuit de remise en forme 500 comprend également une cellule de comparaison multibits 536, reliée d'une part, au bus d'entrée 502, d'autre part, à la sortie de la cellule de mémorisation 543 afin de comparer le signal numérique d'entrée présent sur le bus 502 à la valeur du seuil numérique mémorisé dans la cellule 435.

De façon comparable aux ensembles 510 et 520 précités , la cellule de comparaison 536 peut être formée de comparateurs type 74HC85 montés en cascade.

La sortie de la cellule de comparaison 536 attaque par l'intermédiaire d'une porte OU538 un sous-ensemble suppresseur de parasites 600.

Selon la représentation de la figure 5, la porte OU 538 a trois entrées. Deux de ces entrées sont reliées respectivement aux sorties A = B et A > B du circuit 74HC85 intégré au comparateur 536. La troisième entrée de la porte OU 538 est reliée à la masse.

On va maintenant décrire la structure de l'ensemble de gestion du seuil 550 illustré sur la figure 6.

Ce circuit comprend tout d'abord 3 portes ET à deux entrées 552, 554 et 556.

La porte ET 552 reçoit en entrée un signal CKN (qui correspond soit au signal CK1 soit au signal CK2 générés par le circuit 700, selon qu'il s'agit du circuit de mise en forme 500A ou 500B) et un signal XOR généré par le suppresseur de parasites 600 d'une façon qui sera décrite plus en détail par la suite.

L'une des entrées de la porte ET554 est reliée à la sortie de la porte ET552. L'autre entrée de la porte ET 554 reçoit un signal $\overline{QS}$ généré par le suppresseur de parasites 600 d'une façon qui sera décrite plus en détail par la suite.

L'une des entrées de la porte ET 556 est reliée à la sortie de la porte ET 552 tandis que l'autre entrée de la porte ET 556 reçoit un signal QS généré par le suppresseur de parasites 600 d'une façon qui sera décrite plus en détail par la suite.

La porte OU 512 précitée qui commande le rafraîchissement de la valeur du maximum mémorisé dans la cellule 514 est une porte à 3 entrées. L'une de ces entrées reçoit un signal de contrôle WD qui est généré par le circuit de cadencement 800. Il s'agit en fait soit du signal WD1 soit du signal WD2 générés par ce dernier. Une autre entrée de la porte OU 512 est reliée à la sortie de l'ensemble de recherche de maximum 510. La troisième entrée de la porte OU 512 est reliée à la sortie de la porte ET 554.

De façon similaire la porte OU 522 précitée qui commande le rafraîchissement de la valeur du minimum mémorisé dans la cellule 524 est une porte OU à trois entrées. L'une des entrées reçoit le signal de commande WD précité. Une autre entrée de la porte OU 522 est reliée à la sortie de l'ensemble de recherche de minimum 520. Enfin, la troisième entrée de la porte OU 522 est reliée à la sortie de la porte ET 556.

L'ensemble de gestion 550 comprend 3 sorties principales 580, 582 et 584. La sortie 580 est reliée à l'entrée de commande de mémorisation de la cellule 514 pour commander le rafraîchissement de la valeur du maximum mémorisé.

La sortie 582 est reliée à la commande de mémorisation de la cellule 524 pour contrôler le rafraîchissement du minimum mémorisé.

Enfin, la sortie 584 est reliée à l'entrée de commande de mémorisation de la cellule 543 pour contrôler le rafraîchissement du seuil mémorisé.

Le signal appliqué sur la sortie 580 est généré par une porte ET 558, un inverseur 560 et une bascule D 562.

La porte ET 558 à deux entrées reçoit sur l'une de ses entrées le signal d'horloge H. L'autre entrée de la porte ET558 est reliée à la sortie de la porte OU 512. La sortie de la porte ET558 attaque l'inverseur 560. La sortie de ce dernier est reliée à l'entrée de commande $\overline{PR}$ de la bascule D 562.

Les entrées D et CK de la bascule 562 sont reliées à une tension d'alimentation positive.

L'entrée $\overline{CLR}$ de la bascule 562 reçoit le signal d'horloge H.

La sortie 580 de l'ensemble de gestion 550 est formée par la sortie Q de la bascule 562.

De façon similaire, le signal appliqué sur la sortie 582 est généré par une porte ET 574 à deux entrées, un inverseur 576 et une bascule D 758.

La porte ET 574 reçoit sur ses entrées le signal d'horloge H et la sortie de la porte OU 522.

La sortie de la porte ET 574 est reliée à l'entrée de l'inverseur 576. La sortie de ce dernier est reliée à l'entrée de commande $\overline{PR}$ de la bascule D 578.

Les entrées D et CK de la bascule 578 sont reliées à une tension d'alimentation positive.

L'entrée $\overline{CLR}$ de la bascule 578 reçoit le signal d'horloge H.

La sortie 582 est formée par la sortie Q de la bascule 578.

Enfin, le signal 584 est généré par une porte OU 564, deux inverseurs 566 et 570, une bascule D 568 et une porte ET à deux entrées 572.

L'une des entrées de la porte OU 564 est reliée à la sortie Q de la bascule 562. La sortie de la porte OU 564 attaque l'inverseur 566. La sortie de ce dernier est relié à l'entrée de commande $\overline{PR}$ de la bascule D 568.

Celle-ci reçoit sur son entrée CK le signal d'horloge H. L'entrée D de la bascule 568 est reliée à la masse. L'entrée $\overline{CLR}$ de la bascule 568 est reliée à une tension positive +Vcc.

Les entrées de la porte ET 752 sont reliées respectivement à la sortie Q de la bascule 568 et à la sortie de l'inverseur 570. Ce dernier reçoit en entrée le signal d'horloge H.

La sortie 584 qui est reliée à la cellule de mémorisation 534 pour rafraîchir la valeur du seuil mémorisé est formée par la sortie de la porte ET 572.

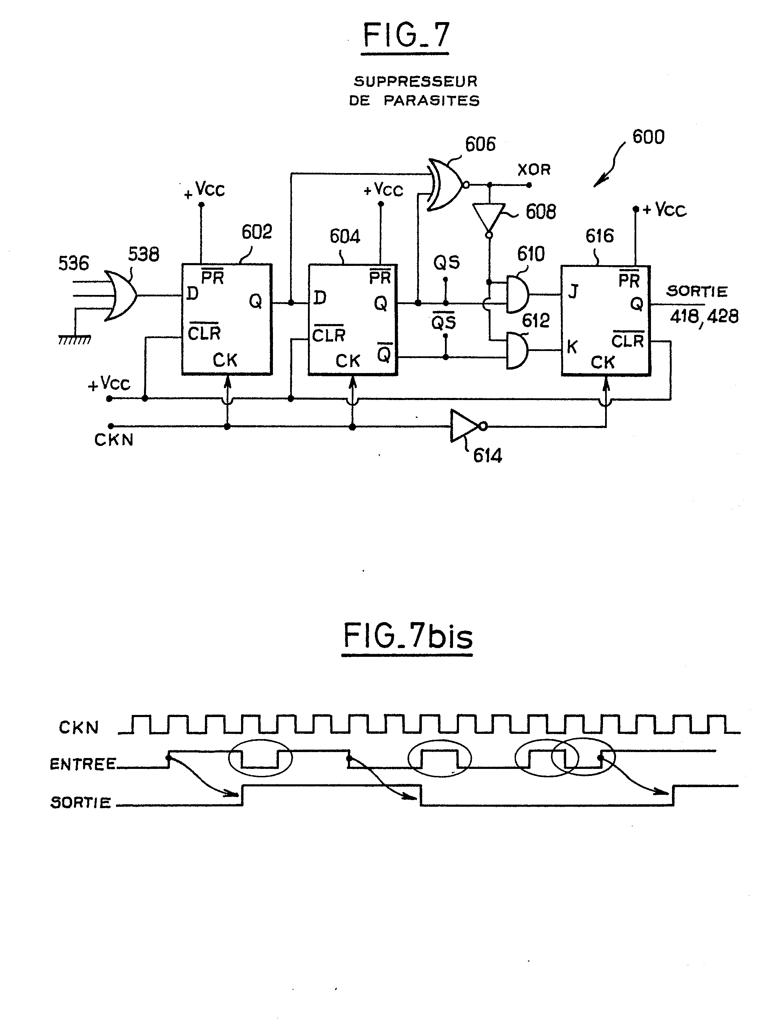

On va maintenant décrire la structure du circuit suppresseur de parasite 600 représenté sur la figure 7. Ce circuit a pour but de supprimer les impulsions du signal logique issu du comparateur 536, via la porte 538, lorsqu'un seul échantillon de ce signal est à zéro ou à 1.

Le circuit suppresseur de parasites 600 comprend deux bascules D 602, 604, une bascule JK 616, une porte NOR 606, deux inverseurs 608 et 614 et deux portes ET à deux entrées 610 et 612.

L'entrée D de la bascule 602 est reliée à la sortie de la porte OU 538. L'entrée de commande CK de la bascule 602 reçoit le signal de commande CK (CK1 ou CK2). La sortie Q de la bascule 602 est reliée à l'entrée D de la bascule 604. Celle-ci reçoit également sur son entrée de commande CK le signal de commande CKN.

Les entrées de la porte NOR 606 sont reliées respectivement aux sorties Q des bascules 602 et 604.

La sortie de la porte NOR 606 est reliée à l'entrée de l'inverseur 608.

Les entrées de la porte ET 610 sont reliées respectivement à la sortie Q de la bascule 604 et à la sortie de l'inverseur 608.

Les entrées de la porte ET 612 sont reliées respectivement à la sortie de l'inverseur 608 et à la sortie $\overline{Q}$ de la bascule 604.

Les sorties des portes ET 610 et 612 sont reliées respectivement aux entrées J et K de la bascule 616.

L'entrée de commande CK de la bascule 616 reçoit par l'intermédiaire d'un inverseur 614 le signal de commande CKN.

La sortie du circuit suppresseur de parasites 600 est formée par la sortie Q de la bascule 616. Cette sortie constitue par ailleurs soit la sortie générale 418, soit la sortie générale 428 selon qu'il s'agit du circuit suppresseur de parasites 600A ou 600B.

Le signal XOR précité appliqué à l'entrée de la porte ET 552 du circuit de gestion de seuil 550 est obtenu en sortie de la porte OU 606.

Par ailleurs, les signaux QS et $\overline{QS}$ appliqués respectivement sur l'une des entrées des portes ET 556 et 554 sont obtenue au niveau des sorties Q et $\overline{Q}$ de la bascule D 604.

On a illustré schématiquement sur la figure 7 bis un chronogramme de fonctionnement du circuit suppresseur de parasites 600.

La première ligne de la figure 7 bis représente le signal de commande CKN appliqué sur les entrées CK des bascules 602, 604 et 616.

La deuxième ligne de la figure 7 bis illustre un exemple de signal d'entrée appliqué sur l'entrée D de la bascule 602.

La troisième ligne de la figure 7 bis illustre le signal obtenu en sortie de la bascule 616.

On comprendra aisément, par comparaison des deuxième et troisième lignes du chronogramme illustré sur la figure 7 bis que le circuit suppresseur de parasites 600 élimine tous les basculements du signal d'entrée qui ne couvrent qu'une seule période du signal de commande formant horloge CKN. Ces basculements éliminés, assimilés à des parasites sont entourés sur la deuxième ligne de la figure 7 bis.

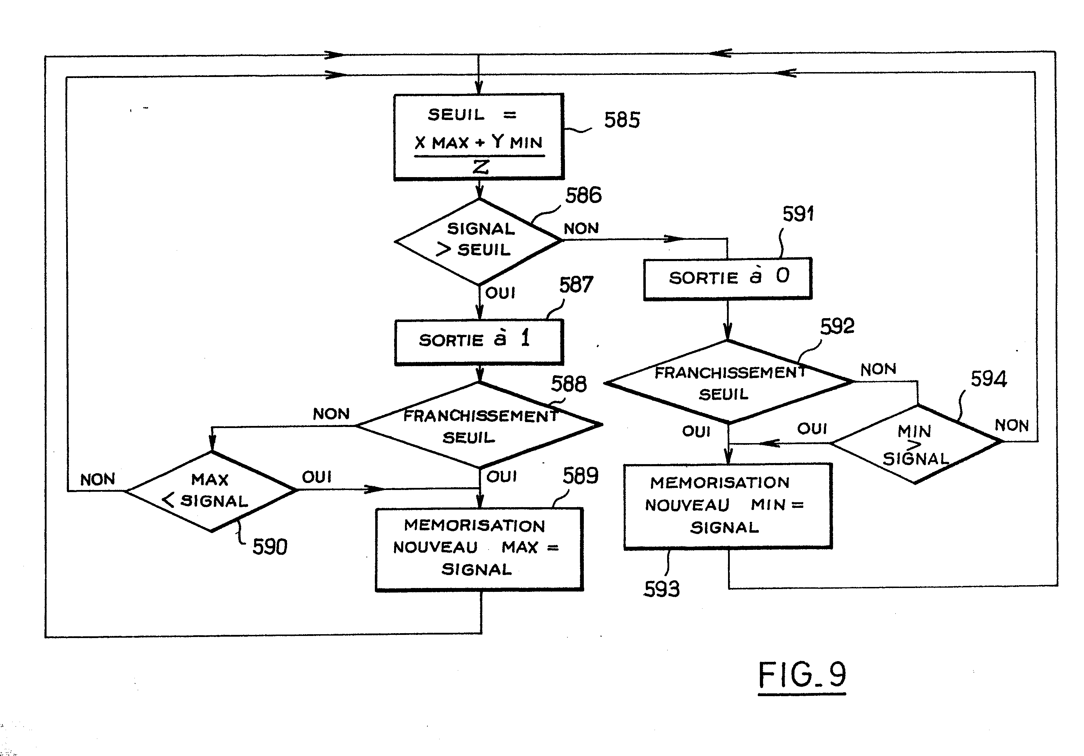

On va maintenant expliciter le fonctionnement du circuit de remise en forme 500 illustré sur la figure 5 en regard des figures 8 et 9 annexées.

La figure 8 représente un diagramme schématique des principaux signaux utilisés dans le circuit de remise en forme 500, tandis que la figure 9 représente un organigramme de fonctionnement de ce circuit.

On a représenté en traits mixtes interrompus sur la figure 8 un signal délivré par un capteur de détection de point mort haut pour véhicules automobiles.

Sur la figure 8, les pics utiles de ce signal sont référencés schématiquement PU. On notera que la ligne de base du signal est ondulée en correspondance au faux rond du volant moteur. Par ailleurs, on aperçoit sur la figure 8, superposées à la ligne de base, des ondulations parasites référencées schématiquement OP dues aux éventuels écrous de fixation du carter d'embrayage et/ou à des trous d'équilibrage réalisés sur le volant.

En partie supérieure de la figure 8, on a également représenté schématiquement la valeur du seuil mémorisée dans la cellule 534 et servant de consigne au comparateur 536, ainsi que les valeurs crête maximale et crête minimale mémorisées respectivement dans les cellules 514 et 524.

Enfin, on a représenté en partie inférieure de la figure 8 le signal de sortie du comparateur 536. On notera, que de façon classique en soi, ce signal en créneau est au niveau logique bas lorsque le signal utile est inférieur à la valeur seuil de consigne, tandis qu'il est au niveau logique haut lorsque le signal utile est supérieur à la valeur seuil de consigne.

Comme illustré schématiquement sur la figure 9, par l'étape 585, les cellules 530 et 532 calculent une valeur de seuil égale à (XMax + Ymin)/Z, par exemple (3Max + min)/4. Cette valeur de seuil mémorisée dans la cellule 534 est comparée, comme schématisé à l'étape 586 sur la figure 9 au signal d'entrée.

Lorsque le signal est inférieur au seuil (ce qui correspond à la partie de la courbe du signal utile avant le point A sur la figure 8) le signal de sortie du comparateur 536 est à 0 comme illustré par l'étape 591 sur la figure 9.

Par contre, lorsque le signal utile est supérieur à la valeur du seuil, la sortie du comparateur 536 passe à 1 comme illustré par l'étape référencée 587 sur la figure 9.

Dans le cas où le fait que le signal soit supérieur à la valeur de seuil correspond à un franchissement par excès de ce dernier (point A sur la figure 8) la réponse positive à l'étape d'interrogation 588 sur la figure 9 conduit à la mémorisation d'un nouveau maximum égal à la valeur du signal lors du franchissement comme illustré par l'étape 589 sur la figure 9. Cette étape 589 est suivie du calcul d'un nouveau seuil à l'étape 585 précitée et d'une nouvelle comparaison du signal et du seuil à l'étape 586. On notera que le seuil est alors abaissé instantanément.

Dans la pratique, le franchissement par excès du seuil par le signal correspond au point A sur la figure 8. Lors du franchissement par excès du seuil la sortie du comparateur 536 passe du niveau logique bas au niveau logique haut. Par conséquent, les lignes XOR et $\overline{QS}$ passent du niveau logique bas au niveau logique haut et produisent sur la sortie Q de la bascule 562 une impulsion d'horloge appliquée à la cellule 514 pour mémoriser une nouvelle valeur de maximum correspondant à la valeur du signal lors de la détection du franchissement par excès.

Par la suite, (évolution du signal entre les points A et B sur la figure 8), l'organigramme illustré sur la figure 9 passe par les étapes 585, 586 qui conserve une réponse positive puisque le signal est supérieur au seuil, 587 puisque la sortie reste à 1 et 588.

Cette étape d'interrogation 588 connaît entre les points A et B une réponse maintenant négative qui conduit à l'étape d'interrogation 590.

Avant que le signal n'atteigne son maximum référencé par le point B sur la figure 8, l'étape 590 connaît une réponse positive, puisque le maximum mémorisé dans la cellule 514 est inférieur au signal. Cela entraîne, comme illustré par l'étape 589 sur la figure 9 le rafraîchissement du maximum mémorisé dans la cellule 514. Le contenu de celle-ci suit dont le signal entre les points A et B. Ce rafraîchissement est commandé par le comparateur 510. Simultanément le seuil calculé par les cellules 530 et 532 évolue.

Par contre, lorsque le signal atteint son maximum référencé B sur la figure 8, l'étape d'interrogation 590 connaît une réponse négative et le fonctionnement du circuit de remise en forme 500 suit alors, entre les points B et C de la courbe du signal, la boucle illustrée par les étapes 585, 586, 587, 588 et 590 sur la figure 9. A partir du point B correspondant au maximum du signal , le seuil reste fixe puisque le maximum mémorisé en 514 reste constant.

Par contre, lorsque le signal devient inférieur au seuil (point C sur la figure 8), l'étape 586 connaît une réponse négative. Le signal de sortie du comparateur 536 passe alors à 0 comme illustré à l'étape 591 sur la figure 9.

Lorsque le fait que le signal soit inférieur au seuil correspond à un franchissement par défaut de ce dernier, l'étape d'interrogation 592 de détection de franchissement connaît une réponse positive. Elle est alors suivie, comme illustré par l'étape 593 sur la figure 9, de la mémorisation d'une nouvelle valeur de minimum égale à la valeur du signal, dans la cellule de mémorisation 524. L'étape 593 est suivie du calcul d'un nouveau seuil à l'étape 585 et d'une nouvelle comparaison du signal et du seuil à l'étape 586. On notera que le seuil est alors élevé instantanément.

Dans la pratique, lorsque le signal franchit par défaut le seuil, la sortie du comparateur 536 passe du niveau logique haut au niveau logique bas.Par conséquent, les lignes XOR et QS passent au niveau logique haut et produisent une impulsion d'horloge sur la sortie Q de la bascule 578 pour appliquer une impulsion d'horloge sur la cellule 524 afin de mémoriser un nouveau minimum correspondant à la valeur du signal.

Par la suite, (évolution du signal entre les points C et D,) l'étape de détection du franchissement du seuil 592 connaît une réponse negative et est suivie par l'étape d'interrogation 594 qui détecte si le minimum mémorisé dans la cellule 524 est supérieur ou non au signal. Entre les points C et D du signal l'étape d'inter rogation 594 connaît une réponse positive et est donc suivie de l'étape 593 de rafraîchissement de la valeur du minimum mémorisé dans la cellule 524. En d'autres termes, entre les points C et D du signal, le fonctionnement du circuit de remise en forme 500 correspond à la boucle déterminée par les étapes 585, 586, 591, 592, 594 et 593. Entre les points C et D le minimum mémorisé dans la cellule 524 suit le signal et le seuil diminue progressivement. Lorsque le signal atteint son minimum (point D sur la figure 8), l'étape d'interrogation 594 connaît une réponse négative et est suivie de l'étape 585. Le seuil reste alors constant.

Le fonctionnement dudit circuit de remise en forme 500 est alors déterminé par la boucle formée des étapes 585, 586, 591, 592, 594 jusqu'à détection d'un nouveau franchissement du seuil.

En conclusion, lorsque celui-ci intervient en A' le fonctionnement du circuit est déterminé à nouveau par la boucle composée des étapes 585, 586, 587, 588 et 589. Entre le franchissement par excès du seuil et l'atteinte d'un maximum (entre les points A' et B') le fonctionnement du dispositif est à nouveau déterminé par la boucle composée des étapes 585, 586, 587, 588, 590, 589. Entre le maximum et le franchissement par défaut du seuil (entre les points B' et C') le fonctionnement du dispositif est déterminé par la boucle composée des étapes 585, 586, 587, 588 et 590. Lors de la détection du franchissement du seuil par défaut le fonctionnement du dispositif est déterminé par la boucle composée des étapes 585, 586, 591, 592, 593. Entre le franchissement du seuil par défaut et l'atteinte du minimum (entre les points C' et D') le fonctionnement du dispositif est déterminé par la boucle composée des étapes 585, 586, 591, 592, 594, 593. Entre le minimum et le nouveau franchissement par excès du seuil (entre les points D' et A ) le fonctionnement du dispositif est déterminé par la boucle composée des étapes 585, 586, 591, 592 et 594.

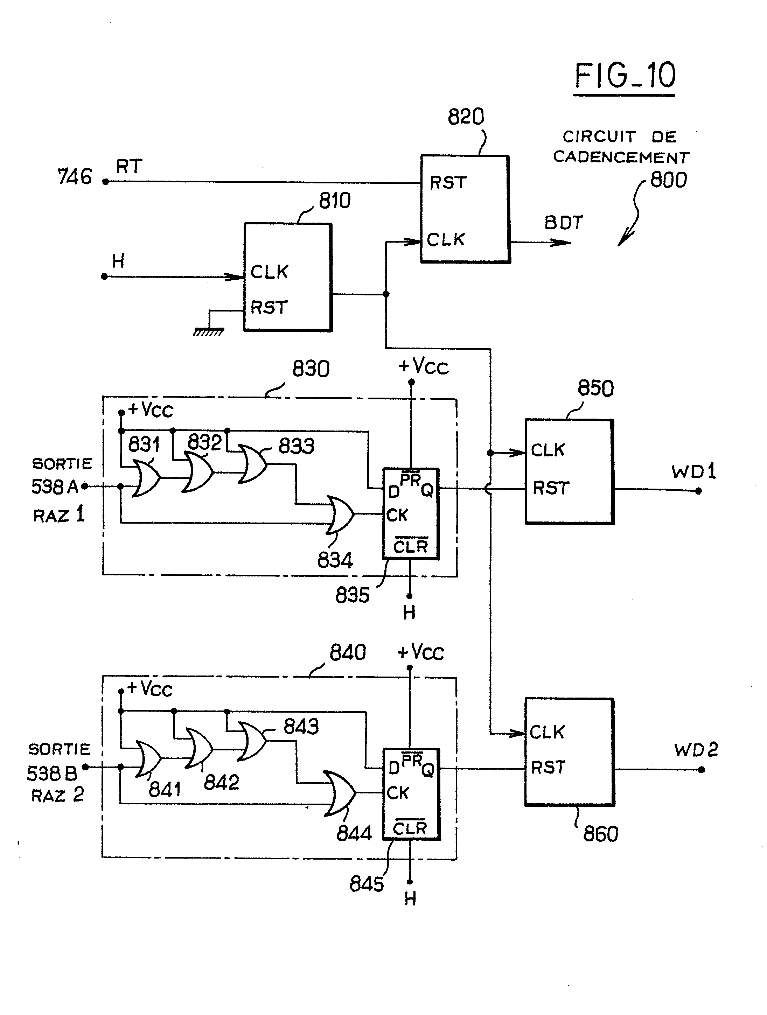

On va maintenant décrire la structure du circuit de cadencement 800 illustré sur la figure 10.

Ce circuit de cadencement 800 reçoit en entrée le signal RT généré par le circuit de gestion 700, le signal d'horloge H, et les signaux générés sur les sorties des circuits de remise en forme 500A et 500B (sorties des portes OU 538) qui lui servent de remise à zéro.

Le circuit de cadencement génère en sortie le signal BDT appliqué au circuit de gestion 700 et les signaux WD1 et WD2 appliqués sur les portes OU 512 et 522 des circuits de mise en forme 500A et 500B respectivement.

Le signal BDT rythme l'échantillonnage des signaux appliqués sur les entrées principales 12 et 13. Il est validé lorsque 0,5sec se sont écoulés depuis le dernier créneau du signal RT généré par le circuit de gestion 700.

Les signaux WD1 et WD2 ont pour but de garantir que le signal de sortie ait une fréquence supérieure à 2Hz. Si durant 0,5 sec il n'y a aucune transition en sortie des circuits de mise en forme 500A et 500B, les signaux WD1 et WD2 que sont validés imposent une mémorisation de nouvelles valeurs dans les cellules 514 et 524 ; ces valeurs égales entre elles, sont égales à la valeur du signal d'entrée. Dans ce cas, le seuil est égal au signal d'entrée.

Le signal BDT est généré par division de la fréquence d'horloge de 1MHz.

Cette division est opérée par un prédiviseur 810 et un compteur 820.

Le prédiviseur 810 peut être formé d'un circuit type 74HC4020 dont l'entrée d'horloge CLK reçoit le signal d'horloge à 1MHz, et dont l'entrée de remise à zéro RST est reliée à la masse.

Le compteur 820 peut être formé d'un circuit type 74 HC4024 dont l'entrée d'horloge CLK est reliée à la sortie du prédiviseur 810 et dont l'entrée de remise à zéro RST reçoit le signal RT généré par le circuit de gestion 700.

La sortie du prédiviseur 810 génère par exemple un signal de fréquence 122,07 Hz.

Les signaux WD1 et WD2 sont générés sur la base des signaux générés en sortie des circuits de mise en forme 500A et 500B, en utilisant le signal issu du prédiviseur 810.

Pour cela, le circuit de cadencement 800 comprend deux circuits 830 et 840 qui détectent le front des signaux issus des portes OU 538.

Chacun des circuits détecteurs de front 830 et 840 comprend 4 portes OU à 2 entrées 831, 832, 833, 834 ; 841, 842, 843, 844 et une bascule D 835, 845.

Les entrées de la porte OU 831 reliées respectivement à une tension d'alimentation positive +Vcc et à la sortie de la porte OU 538 précitée.

Les entrées de la porte OU 832 sont reliées respectivement à la tension d'alimentation positive +Vcc et à la sortie dela porte OU 831.

Les entrées de la porte OU 833 sont reliées respectivement à la tension d'alimentation positive +Vcc et à la sortie de la porte OU 832.

Les entrées de la porte OU 834 sont reliées respectivement à la sortie de la porte OU 833 et à la sortie de la porte OU 538A.

La sortie de la porte OU 834 attaque l'entrée d'horloge CK de la bascule 835. L'entrée D de cette dernière ainsi que son entrée $\overline{PR}$ sont reliées à la tension d'alimentation positive +Vcc. Son entrée $\overline{CLR}$ de remise à zéro reçoit le signal d'horloge H.

De façon similaire, les entrées de la porte OU 841 sont reliées respectivement à une tension d'alimentation positive +Vcc et à la sortie de la porte OU 538 B précitée.

Les entrées de la porte OU 842 sont reliées respectivement à la tension d'alimentation positive +Vcc et à la sortie de la porte OU 841.

Les entrées de la porte OU 843 sont reliées respectivement à la tension d'alimentation positive +Vcc et à la sortie de la porte OU 842.

Les entrées de la porte OU 844 sont reliées respectivement à la sortie de la porte OU 843 et de la porte OU 538 B.

La sortie de la porte OU 844 est reliée à l'entrée d'horloge H de la bascule 845.

L'entrée D de cette dernière, ainsi que son entrée $\overline{PR}$ sont reliées à la tension d'alimentation positive +Vcc. Son entrée $\overline{CLR}$ de remise à zéro reçoit le signal d'horloge H.

Les détecteurs de front 830 et 840 sont suivis chacun d'un diviseur de fréquence 850, 860 respectivement.

Ces diviseurs 850, 860 peuvent être formés de circuits type 74HC4024, qui reçoivent sur leur entrée d'horloge CLK la sortie du prédiviseur 810 et dont l'entrée de remise à zéro RST est reliée respectivement à la sortie Q des bascules 835, 845.

Enfin, la remise en forme des signaux appliqués sur l'entrée principale 14, qui correspondent à des signaux représentatifs du débit, est assurée par deux triggers de Schmitt 910, 920 montés en cascade. Il peut s'agir par exemple de circuits type 74HC14.

La sortie du second trigger de Schmitt 920 est reliée à la sortie générale 458 du circuit.

En résumé, le signal fréquentiel appliqué sur l'entrée 10 du circuit, qui représente la vitesse du véhicule, est successivement : 1) filtré dans le filtre 100A, 2) échantillonné dans le multiplexeur 200, 3) converti en donnée numérique par le convertisseur 300, 4) démultiplexé, au niveau de chaque bit, par le démultiplexeur 400, 5) remis en forme par le circuit 500A, c'est-à-dire transformé en un signal logique (monobit) tout ou rien dont le fondamental a la même fréquence que celui du signal d'entrée, puis 6) soumis au suppresseur de parasites 600A. Le signal de sortie fréquentiel monobit, correspondant au signal d'entrée appliqué sur la voie 10, est disponible sur la sortie 418.

De façon similaire, le signal fréquentiel appliqué sur l'entrée 20 du circuit, qui représente le régime, est successivement : 1) filtré dans le filtre 100B, 2) échantillonné dans le multiplexeur 200, 3) converti en donnée numérique par le convertisseur 300, 4) démultiplexé, au niveau de chaque bit, par le démultiplexeur 400, 5) remis en forme par le circuit 500B, c'est-à-dire transformé en un signal logique (monobit) tout ou rien dont le fondamental a la même fréquence que celui du signal d'entrée, puis 6) soumis au suppresseur de parasite 600B. Le signal de sortie fréquentiel, monobit, correspondant au signal d'entrée appliqué sur la voie 11 est disponible sur la sortie 428.

Le signal analogique appliqué sur l'entrée 12 du circuit, qui représente le niveau de carburant, est successivement : 1) échantillonné par le multiplexeur 200, 2) converti en donnée numérique multibits par le convertisseur 300, et 3) démultiplexé au niveau de chaque bit par le démultiplexeur 400. Le signal de sortie numérique correspondant au signal d'entrée appliqué sur la voie 12 est disponible sur le bus de sortie 438.

De façon similaire, le signal analogique appliqué sur l'entrée 13 du circuit, qui représente un paramètre du fonctionnement du véhicule, est successivement : 1) échantillonné par le multiplexeur 200, 2) converti en donnée numérique multibits par le convertisseur 300, et 3) démultiplexé au niveau de chaque bit par le démultiplexeur 400. Le signal de sortie numérique correspondant au signal d'entrée appliqué sur la voie 13 est disponible sur le bus de sortie 448.

Enfin, le signal fréquentiel appliqué sur l'entrée 14 du circuit, qui représente le débit de carburant, est remis en forme par les triggers de Schmitt 910, 920 et disponible sur la sortie 458.

De préférence, le circuit de traitement conforme à la présente invention, bien que décrit précédemment sous forme d'une logique câblée, sera réalisé sous forme d'un circuit intégré.

Bien entendu, la présente invention n'est pas limitée au mode de réalisation particulier qui vient d'être décrit, mais s'étend à toute variante conforme à son esprit.

En particulier, le circuit de traitement conforme à la présente invention peut avoir d'autres applications que le domaine automobile.

## Revendications

1. Circuit de traitement d'un signal analogique du type comprenant au moins un circuit de mise en forme qui comporte :
- des moyens (510, 520) de détection des maxima et des minima d'un signal d'entrée,
- des moyens (530, 532, 534) définissant une valeur seuil de consigne correspondant à un pourcentage prédéterminé de l'écart entre le dernier maximum et le dernier minimum du signal d'entrée, et
- des moyens (536) de comparaison de la valeur du signal d'entrée et de la valeur seuil de consigne pour générer un signal de sortie basculant entre deux états en fonction du résultat de la comparaison, caractérisé par le fait que :
- le circuit de mise en forme (500) est précédé d'un convertisseur analogique/numérique (300), et que
- les maxima et minima détectés du signal d'entrée sont stockés de façon numérique dans des moyens de mémoire (514, 524).

2. Circuit de traitement selon la revendication 1, caractérisé par le fait que les moyens (510, 514 ; 520, 524) de détection des maxima et des minima du signal d'entrée, comprennent deux cellules de mémorisation multibits (514, 524) aptes à mémoriser de façon numérique respectivement une valeur de maximum et une valeur de minimum et deux comparateurs multibits (510, 520) aptes à comparer respectivement le contenu de l'une des cellules de mémorisation et le signal d'entrée, pour rafraîchir le contenu de la cellule de mémorisation de maximum (514) lorsque le signal d'entrée devient supérieur à celui-ci ou rafraîchir le contenu de la cellule de mémorisation de minimum (524) lorsque le signal d'entrée devient inférieur à celui-ci.

3. Circuit selon l'une des revendications 1 et 2, caractérisé par le fait que les moyens (536) de comparaison de la valeur du signal d'entrée et de la valeur seuil de consigne sont associés à des moyens (604) aptes à discriminer un franchissement par excès et un franchissement par défaut, de la valeur seuil consigne, par le signal d'entrée, pour remplacer le dernier maximum par le signal d'entrée lors d'un franchissement par excès et pour remplacer le dernier minimum par le signal d'entrée, lors d'un franchissement par défaut.

4. Circuit selon les revendications 2 et 3 prises en combinaison, caractérisé par le fait que les moyens (536) de comparaison de la valeur du signal d'entrée et de la valeur seuil de consigne sont associés à des moyens (604) aptes à discriminer un franchissement par excès et un franchissement par défaut de la valeur seuil de consigne, par le signal d'entrée, pour remplacer le dernier maximum mémorisé dans la cellule de mémorisation de maximum (514), par le signal d'entrée, lors d'un franchissement par excès, de telle sorte que le contenu de la cellule de mémorisation de maximum (514) suive par la suite le signal d'entrée jusqu'à détection d'un nouveau maximum du signal d'entrée, et pour remplacer le dernier minimum mémorisé dans la cellule de mémorisation du minimum (524), par le signal d'entrée, lors d'un franchissement par défaut, de telle sorte que le contenu de la cellule de mémorisation de minimum (524) suive par la suite le signal d'entrée jusqu'à détection d'un nouveau minimum du signal d'entrée.

5. Circuit selon l'une des revendications 2 à 4, caractérisé par le fait qu'il comprend des moyens (830, 850 ; 840, 860) aptes à imposer un rafraîchissement des valeurs mémorisées dans les cellules de mémorisation de maximum et de minimum (514 ; 524) si le signal de sortie des moyens (536) de comparaison de la valeur du signal d'entrée et de la valeur seuil de consigne, n'a pas basculé dans une période déterminée, par exemple de l'ordre de 0,5 sec.

6. Circuit selon l'une des revendications 1 à 5, caractérisé par le fait que le circuit de remise en forme est suivi d'un circuit suppresseur de parasites (600) apte à supprimer les impulsions du signal logique issu des moyens (536) de comparaison de la valeur du signal d'entrée et de la valeur seuil de consigne, lorsque ces impulsions correspondent à un basculement du signal logique limité à un nombre prédéterminé de périodes d'un signal d'échantillonnage.

7. Circuit selon la revendication 6, caractérisé par le fait que le circuit de remise en forme (500) est suivi d'un circuit suppresseur de parasites (600) apte à supprimer les impulsions du signal logique issu des moyens (536) de comparaison de la valeur du signal d'entrée et de la valeur seuil de consigne, lorsque ces impulsions correspondent à un basculement du signal logique limité à une période d'un signal d'échantillonnage.

8. Circuit selon l'une des revendications 6 ou 7, caractérisé par le fait que le circuit suppresseur de parasites (600) comprend trois bascules (602, 604, 616) montées en cascade, la première bascule (602) recevant comme signal de commande en entrée le signal issu des moyens (536) de comparaison de la valeur du signal d'entrée et de la valeur seuil de consigne, les trois bascules (602, 604, 616) recevant comme signal d'horloge (CK) ledit signal d'échantillonnage, et la dernière bascule (616) étant commandée par une porte logique (606) qui forme une combinaison logique des signaux issus des première et seconde bascules (602, 604).

9. Circuit selon l'une des revendications 1 à 8, caractérisé par le fait que le convertisseur analogique/numérique (300) établit une conversion non linéaire.

10. Circuit selon l'une des revendications 1 à 9, caractérisé par le fait que le convertisseur analogique/numérique (300) est précédé d'un organe multiplexeur (200) et suivi d'un organe démultiplexeur (400).

11. Circuit selon la revendication 10, caractérisé par le fait que certaines des entrées de l'organe multiplexeur (200) sont précédées d'un filtre passe bas (100A, 100B).

12. Circuit selon la revendication 11, caractérisé par le fait que le filtre passe bas (100A, 100B) est un filtre (RC) du deuxième ordre.

13. Circuit selon l'une des revendications 1 à 12, caractérisé par le fait qu'il comprend :
- plusieurs bornes d'entrée (10, 11, 12, 13) aptes à recevoir des signaux électriques respectifs,
- un organe multiplexeur (200) à sortie unique dont les entrées (212, 222, 232, 242) sont reliées respectivement aux bornes d'entrée précitées,
- un convertisseur analogique/numérique (300) relié en sortie de l'organe multiplexeur (200),
- un organe démultiplexeur (400) relié en sortie du convertisseur analogique/numérique (300) et qui comporte autant de voies que l'organe multiplexeur (200),
- plusieurs bornes de sortie (418, 428, 438, 448) reliées respectivement aux sorties de l'organe démultiplexeur (400), et
- au moins un circuit de mise en forme (500) inséré entre une sortie de l'organe démultiplexeur (400) et la borne de sortie associée.

14. Circuit selon la revendication 13, caractérisé par le fait qu'un circuit de mise en forme (500) est inséré entre chaque sortie de l'organe démultiplexeur (400) et la borne de sortie associée (418, 428) correspondant à une voie de signal fréquentiel.

15. Circuit selon l'une des revendications 13 ou 14, caractérisé par le fait qu'un filtre passe bas (100A, 110B) est inséré entre chaque borne d'entrée (10, 11) et l'entrée associée (212, 222) de l'organe multiplexeur (200) correspondant à une voie de signal fréquentiel.

16. Circuit selon l'une des revendications 1 à 15, caractérisé par le fait que les moyens (530, 532, 534) définissant une valeur seuil de consigne, déterminent une valeur seuil comprise entre 50 et 80 % de l'écart entre le maximum mémorisé et le minimum mémorisé du signal d'entrée en étant de préférence de l'ordre de 75 % de cet écart.

17. Circuit selon l'une des revendications 1 à 16, caractérisé par le fait que les moyens définissant la valeur seuil de consigne sur la base du maximum mémorisé et du minimum mémorisé du signal d'entrée comprennent exclusivement des additionneurs (530, 532).

18. Circuit selon l'une des revendications 1 à 17, caractérisé par le fait que les moyens définissant la valeur seuil de consigne comprennent des additionneurs qui additionnent (530, 532) le maximum mémorisé et le minimum mémorisé du signal d'entrée sous la forme

$$\frac{XMax + Ymin}{Z},$$

relation dans laquelle :
. Max représente la valeur du Maximum mémorisé,
. min représente la valeur du minimum mémorisé,
. X, Y et Z représentent des nombres entiers tels que X/Z égale le pourcentage prédéterminé recherché de l'écart entre le maximum et le minimum du signal d'entrée, et

$$Y/Z = \frac{(100 - X).}{100}$$

19. Circuit selon l'une des revendications 17 et 18, caractérisé par le fait que les moyens additionneurs (530, 532) qui définissent la valeur seuil de consigne additionnent le maximum mémorisé et le minimum mémorisé du signal d'entrée sous la forme :

$$\frac{3 Max + min}{4}$$

relation dans laquelle :
. Max représente la valeur du Maximum, et
. min représente la valeur du minimum.

FIG_1

0267072

FIG_2

0267072

FIG_3

GESTION DE LA CONVERSION

REMISE A ZERO GENERALE

BAD ORIGINAL

# FIG_4

GESTION DE LA CONVERSION

FIG. 5

REMISE EN FORME

FIG.6

GESTION DU SEUIL

MEMORISATION NOUVEAU MAXIMUM

MEMORISATION NOUVEAU SEUIL

MEMORISATION NOUVEAU MINIMUM

0267072

# FIG_7

SUPPRESSEUR
DE PARASITES

# FIG_7bis

0267072

# FIG_8

CRÊTE MAXIMUM
MEMORISEE
( 514 )

Ⓑ

Ⓐ

SEUIL ( 534 )

Ⓒ

Ⓐ'

Ⓑ'

OP

PU

SIGNAL D'ENTREE ( 502 )

CRÊTE MINIMUM
MEMORISEE ( 524 )

Ⓓ

SIGNAL DE SORTIE
DU COMPARATEUR
536

FIG.9

0267072

FIG_10

CIRCUIT DE CADENCEMENT 800

0267072

FIG_11

QS
Q̄S
CKN 700
XOR

556
OU_MIN

74HC08 552
74HC08 554
OU_MAX
550

H
74HC08 558
74HC04 560
H

74HC74
PR
D Q
CK Q̄
CLR
562

vers 564
580

vers 530 8 bits

WD PROVENANT DE 800

510
BUS.CRETE.MAX 8 bits

74HC85
DMAX1 10 A0
DMAX2 12 A1
DMAX3 13 A2
DMAX4 15 A3
2 A<B A<B 7
3 A=B A=B 6
4 A>B A>B 5
DB1 9 B0
DB2 11 B1
DB3 14 B2
DB4 1 B3

74HC85
DMAX5 10 A0
DMAX6 12 A1
DMAX7 13 A2
DMAX8 15 A3
2 A<B A<B 7
3 A=B A=B 6
4 A>B A>B 5
DB5 9 B0
DB6 11 B1
DB7 14 B2
DB8 1 B3

74HC4075 512
OU_MAX

74HC374
DB1 3 1D 1Q 2 DMAX1
DB2 4 2D 2Q 5 DMAX2
DB3 7 3D 3Q 6 DMAX3
DB4 8 4D 4Q 9 DMAX4
DB5 13 5D 5Q 12 DMAX5
DB6 14 6D 6Q 15 DMAX6
DB7 17 7D 7Q 16 DMAX7
DB8 18 8D 8Q 19 DMAX8
11 CK
1 OC
514

PROVENANT DE 400
502
ENTREE.DONNEES 8 bits

74HC85
DB1 10 A0
DB2 12 A1
DB3 13 A2
DB4 15 A3
2 A<B A<B 7
3 A=B A=B 6
4 A>B A>B 5
DMIN1 9 B0
DMIN2 11 B1
DMIN3 14 B2
DMIN4 1 B3

74HC85
DB5 10 A0
DB6 12 A1
DB7 13 A2
DB8 15 A3
2 A<B A<B 7
3 A=B A=B 6
4 A>B A>B 5
DMIN5 9 B0
DMIN6 11 B1
DMIN7 14 B2
DMIN8 1 B3

74HC4075 522
OU_MIN
CKMIN 582

Vers 574

74HC374
DB1 3 1D 1Q 2 DMIN1
DB2 4 2D 2Q 5 DMIN2
DB3 7 3D 3Q 6 DMIN3
DB4 8 4D 4Q 9 DMIN4
DB5 13 5D 5Q 12 DMIN5
DB6 14 6D 6Q 15 DMIN6
DB7 17 7D 7Q 16 DMIN7
DB8 18 8D 8Q 19 DMIN8
11 CK
1 OC
524

520
BUS.CRETE.MIN 8 bits

Vers 532
584 8 bits
DE 572

Vers 536

74HC374
SL1 3 1D 1Q 2 COMP1
SL2 4 2D 2Q 5 COMP2
SL3 7 3D 3Q 6 COMP3
SL4 8 4D 4Q 9 COMP4
SL5 13 5D 5Q 12 COMP5
SL6 14 6D 6Q 15 COMP6
SL7 17 7D 7Q 16 COMP7
SL8 18 8D 8Q 19 COMP8
11 CK
1 OC
534

74HC85
DB1 10 A0
DB2 12 A1
DB3 13 A2
DB4 15 A3
2 A<B A<B 7
3 A=B A=B 6
4 A>B A>B 5
COMP1 9 B0
COMP2 11 B1
COMP3 14 B2
COMP4 1 B3

74HC85
DB5 10 A0
DB6 12 A1
DB7 13 A2
DB8 15 A3
2 A<B A<B 7
3 A=B A=B 6
4 A>B A>B 5
COMP5 9 B0
COMP6 11 B1
COMP7 14 B2
COMP8 1 B3

Vers 538

BUS SEUIL DE COMPARAISON 8 bits
de 532

# FIG_11

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X | PATENT ABSTRACTS OF JAPAN, vol. 8, no. 248 (P-313)[1685], 14 novembre 1984; & JP-A-59 121 485 (TATEISHI DENKI K.K.) 13-07-1984<br>* Figure; page (P-313)[1685] * | 1 | H 03 K 5/08 |
| A | Idem<br>--- | 2-5 | |
| Y | US-A-3 832 577 (HARR)<br>* Figures 2-5; colonne 3, ligne 24 - colonne 6, ligne 53 *<br>--- | 1-5,16-19 | |
| Y | FR-A-2 445 067 (HITACHI, LTD et al.)<br>* Figures 1,2,3; page 1, ligne 19 - page 6, ligne 20 *<br>--- | 1-5,16-19 | |
| A | US-A-4 308 502 (BROLIN)<br>* Figures 1,2; colonne 2, ligne 36 - colonne 4, ligne 20 *<br>--- | 6,7,8 | |
| A | US-A-4 525 635 (GILLBERG)<br>* Figures 1,2; colonne 2, ligne 8 - colonne 5, ligne 2 *<br>--- | 6-8 | DOMAINES TECHNIQUES RECHERCHES (Int. Cl.4) |
| A | DE-A-2 534 235 (COMPUTER GESELLSCHAFT)<br>* Figures 1,2; page 4, ligne 11 - page 16, ligne 17 *<br>--- | 1-4 | H 03 K<br>G 06 K |
| A | EP-A-0 083 213 (GENERAL ELECTRIC COMPANY)<br>----- | 1 | |

Le présent rapport a été établi pour toutes les revendications

| Lieu de la recherche | Date d'achèvement de la recherche | Examinateur |
|---|---|---|
| LA HAYE | 08-01-1988 | FEUER F.S. |